Europäisches Patentamt

European Patent Office

Office européen des brevets

(11) Veröffentlichungsnummer: **0 240 883**
**A2**

(12) **EUROPÄISCHE PATENTANMELDUNG**

(21) Anmeldenummer: 87104644.7

(22) Anmeldetag: 28.03.87

(51) Int. Cl.4: **H02J 7/00 , G01R 31/36**

(30) Priorität: **05.04.86 DE 3611484**

(43) Veröffentlichungstag der Anmeldung:
**14.10.87 Patentblatt 87/42**

(84) Benannte Vertragsstaaten:
**DE FR GB IT**

(71) Anmelder: **CEAG Licht- und
Stromversorgungstechnik GmbH
Senator-Schwartz-Ring 26
D-4770 Soest(DE)**

(72) Erfinder: **Jütte, Reinhold
Bararastrasse 32
D-3538 Marsberg(DE)**

(74) Vertreter: **Rupprecht, Klaus, Dipl.-Ing. et al
c/o CEAG Licht- und
Stromversorgungstechnik GmbH
Zentralbereich Patente Postfach 351
D-6800 Mannheim 1(DE)**

(54) Verfahren zur Erzielung eines Tiefentladeschutzes für eine wiederaufladbare Batterie und Schaltungsanordnung zur Durchführung des Verfahrens.

�հ Ein Verfahren zur Erzielung eines Tiefentladungsschutzes für eine wiederaufladbare Batterie (11), mit der ein Verbraucher ($h_1$) versorgt wird, verläuft so, daß bei Unterschreiten der Batteriespannung unter einen vorgegebenen ersten Wert die Versorgungsspannung für den Verbraucher ($h_1$) zunächst periodisch getaktet unterbrochen wird, so daß der Spannungsmittelwert der Spannung am Verbraucher reduziert wird, und daß bei Unterschreiten der Batteriespannung unter einen vorgegebenen zweiten Wert die Versorgungsspannung ganz abgeschaltet wird. Die Schaltungsanordnung mit dem das Verfahren durchgeführt wird, besitzt in dem Lampenstromkreis (10) einen Taktschalter (S3), der von einer Vergleicherschaltung getaktet ein-bzw. ausgeschaltet wird. Hierdurch wird erreicht, daß bei Unterschreiten eines ersten Wertes die Helligkeit des Verbrauchers langsam abnimmt, so daß der Benutzer eine Verringerung der Kapazität der Batterie (11) erkennt, ohne daß aber die Batterie zu stark belastet wird und sich dabei tiefentladen kann.

Bild 1

## Verfahren zur Erzielung eines Tiefentladeschutzes für eine wiederaufladbare Batterie und Schaltungsanordnung zur Durchführung des Verfahrens

Die Erfindung betrifft ein Verfahren gemäß dem Oberbegriff des Patentanspruches 1.

Ein Verfahren bzw. eine Schaltungsanordnung der eingangs genannten Art werden im wesentlichen bei tragbaren Leuchten mit wiederaufladbaren Batterien benutzt bzw. eingesetzt.

Tragbare Leuchten, die aus wiederaufladbaren Batterien versorgt werden, sind mit einem Tiefentladeschutz ausgerüstet. Sinn einer solchen Maßnahme ist es, die Nickel-Cadmium oder Bleiakkumulatoren oder -batterien vor einer schädigenden Tiefentladung zu schützen. Eine solche Tiefentladung liegt dann vor, wenn batteriespezifische Spannungswerte bei einer Entladung unterschritten werden. Der Stand der Technik sieht dabei Tiefentladungsschutzschaltungen, die bei Erreichen einer noch zulässigen unteren Spannungsgrenze den Verbraucher, der z.B. eine Glühlampe sein kann, von der Batterie trennen. Eine Wiedereinschaltsperre verhindert das Wiedereinschalten des Verbrauchers, wenn sich die Batterie erholt und wenn dabei die Batteriespannung ansteigt. Das Rücksetzen des Tiefentladeschutzes erfolgt durch Aus-und Wiedereinschalten der Leuchte.

Der Nachteil bekannter Tiefentladeschutzschaltungen bzw. -verfahren besteht darin, daß der Verbraucher abrupt ausgeschaltet wird. Die Batterie wird zwar dadurch geschützt, die Nachteile aber beim Betrieb in der Praxis sind offensichtlich. Dies ist der Fall, wenn eine tragbare Leuchte zur Ausleuchtung von z.B. Gefahrenstellen benutzt wird und bei Erreichen des unteren Batteriespannungswertes abgeschaltet. Dadurch wird das Ausleuchten von Gefahrenstellen beendet, wichtige Reparaturarbeiten können nicht mehr weitergeführt werden. Leuchten ohne Tiefentladeschutz haben dabei einen Vorteil: Der Benutzer sieht am immer schwächer werdenden Lichtstrom der Lampe, daß die Batteriekapazität sich langsam erschöpft und kann entsprechende Maßnahmen ergreifen, die Gefahrenstelle z.B. verlassen, die Reparaturarbeiten unterbrechen und dergleichen. Der Nachteil besteht aber darin, daß dann die Batterien bis u.U. unter die Tiefentladegrenze betrieben werden, was dann eine Schädigung bis zum Totalausfall der Batterie zur Folge hat. Bleibatterien, die im Vergleich zu Nickel-Cadmium-Batterien im Tiefentladeverhalten wesentlich schlechter abschneiden, sind schon nach ungefähr 10 Zyklen auf einen Spannungswert von kleiner als 1 Volt/Zelle entladen und damit unbrauchbar.

Aufgabe der Erfindung ist es, ein Verfahren und eine Schaltungsanordnung der eingangs genannten Art anzugeben, bei der die oben erwähnten Nachteile vermieden werden. Insbesondere soll erreicht werden, daß bis zum endgültigen Ausschalten zur Erzielung des Tiefentladeschutzes eines Signalisierung der nachlassenden Batteriekapazität erzeugt wird.

Diese Aufgabe wird erfindungsgemäß durch die kennzeichnenden Merkmale des Anspruches 1 gelöst.

Weitere vorteilhafte Ausgestaltungen der Erfindung sind dem Anspruch 2 zu entnehmen.

Die Erfindung besteht also darin, daß nach Unterschreiten eines vorgegebenen ersten Wertes der Batteriespannung die Versorgungsspannung getaktet ein-und ausgeschaltet wird, wobei der Spannungsmittelwert am Verbraucher reduziert wird. Verwendet man eine Glühlampe, wird dabei die Helligkeit der Glühlampe reduziert und der Benutzer kann die Verringerung der Batteriekapazität erkennen. Bei Unterschreitung eines zweiten vorgegebenen Wertes, wenn also die Tiefentladung droht, wird dann der gesamte Batteriestrom (Verbraucher) abgeschaltet.

Aufgrund des pulslängen modulierten Taktbetriebes in dem Bereich zwischen dem ersten und dem zweiten Grenzwert in Abhängigkeit von der Batteriespannung reduziert sich die Helligkeit der Lampe kontinuierlich bis zum Abschaltzeitpunkt; auch dies hilft dann dem Benutzer, die Gefahrenstelle rechtzeitig zu verlassen bzw. eventuelle Reparaturarbeiten einzustellen; eine unverhoffte Ausschaltung der Lampe wird dann nicht mehr zu befürchten sein.

Die Schaltungsanordnung, mit der das erfindungsgemäße Verfahren durchgeführt wird, ist aus den kennzeichnenden Merkmalen des Anspruches 3 zu entnehmen.

Weitere vorteilhafte Ausgestaltungen und Verbesserungen der Schaltungsanordnung sind aus den weiteren Unteransprüchen zu entnehmen.

Anhand der Zeichnung, in der ein Ausführungsbeispiel der Erfindung dargestellt ist, soll die Erfindung sowie weitere vorteilhafte Ausgestaltungen und Verbesserungen näher erläutert und beschrieben werden.

Es zeigt:

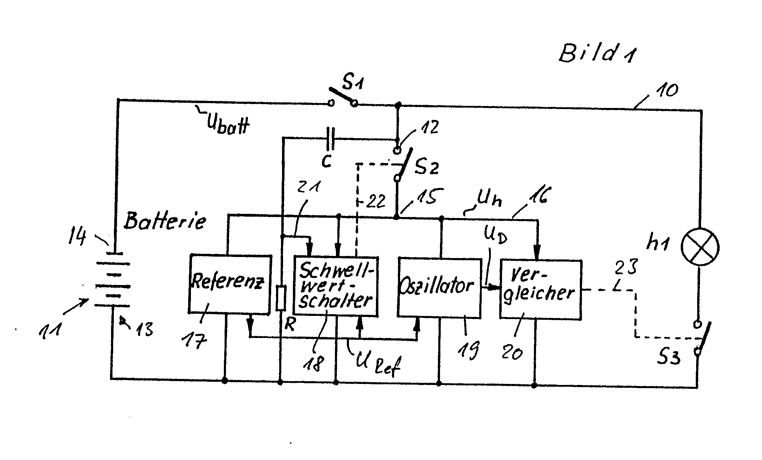

Bild 1: Eine schematische Block-Bild-Darstellung der erfindungsgemäßen Schaltungsanordnung,

Bild 2: eine detaillierte Darstellltung der Schaltungsanordnung gemäß Bild 1 und

Bild 3: eine grafische Darstellung des Lichtstromes über der Batteriespannung.

Eine Glühlampe h1 befindet sich in einem Glühlampenstromkreis 10, der von einer Batterie 11 mit Energie versorgt wird. Im Glühlampenstromkreis 10 befindet sich vor der Glühlampe h1 ein erster Schalter S1; zwischen dem ersten Schalter S1 und der Glühlampe ist eine Anschlußklemme 12 eines zweiten Schalters S2 geschaltet und im Glühlampenstromkreis 10 hinter der Glühlampe h1 ist ein dritter Schalter S3 eingeschaltet. Zwischen dem Glühlampenstromkreis 10 und der Anschlußklemme 12 ist ein Bein eines Differenziergliedes angeschlossen, das aus einem Kondensator C und einem Widerstand R gebildet wird; das andere Bein des Differenziergliedes ist an den negativen Pol 13 der Batterie angeschlossen. Der Pluspol der Batterie besitzt die Bezugsziffer 14. Der andere Anschluß 15 des Schalters liegt an einer Leitung 16 an, die mit einer Referenzschaltung 17 verbunden ist; die Schaltungsanordnung besitzt weiterhin einen Schwellwertschalter 18, einen Oszillator 19 und eine Vergleicherschaltung 20. Über das Differenzierglied R/C wird dem Schwellwertschalter 18 über eine zwischen dem Kondensator C und dem Widerstand R angeschlossene Leitung 21 ein Spannungsimpuls gegeben. Dadurch schließt der Schwellwertschalter 18 über die strichpunktiert gezeichnete Leitung 22 den elektronischen Schalter S2. Dadurch steht an der Leitung 16 die Batteriespannung bezeichnet mit $U_h$ an. Der Schwellwertschalter vergleicht die von der Referenzschaltung 17 abgegebene Spannung mit der Batteriespannung $U_h$, und dann wen $U_h$ größer ist als die Referenzspannung $U_{Ref}$, gibt der Schwellwertschalter über die Leitung 22 das "Ein"-Signal an den Schalter S2, der dann geschlossen bleibt. Die Schaltung versorgt sich somit selbst (Selbsthalteschaltung).

Der Oszillator 19 erzeugt eine Dreieckspannung $U_D$, die von der Referenzspannung $U_{Ref}$ gesteuert einen Amplitudenhöchstwert

$$U_{Ref} + U_D$$

und einen Amplitudenniedrigstwert

$$U_{Ref} - U_D$$

hat. Die Dreieckspannung $U_D$ wird vom Vergleicher mit der Batteriespannung $U_h$ verglichen. Ist

$$U_h > U_{Ref} + U_D$$

dann wird über die weitere strichpunktierte Leitung 23 der elektronische Schalter S3 dauernd eingeschaltet und die Glühlampe H1 brennt. Sinkt im Laufe der Entladung die Batteriespannung $U_{batt}$ (entspricht $U_h$), so wird bei Unterschreiten der Schwelle

$$U_{Ref} + U_D$$

der Schalter S3 nicht mehr dauernd eingeschaltet, sondern periodisch mit einem Taktverhältnis, das dem Momentanwert der Batteriespannung entspricht. Dadurch wird der Spannungsmittelwert an der Lampe H1 reduziert; der Lichtstrom nimmt ab. Durch entsprechende Dimensionierung kann der Lichtstrom soweit abnehmen, daß er bei Erreichen des Tiefentladeschutzgrenzwertes nur noch wenige Prozent des Nennlichtstromes - beträgt. Der Tiefentladeschutz wird aus der Zusammenwirkung der Referenzschaltungsanordnung, dem Schwellwertschalter und dem Schalter S2 gebildet. Erreicht die Batteriespannung den Wert $U_h$ kleiner $U_{Ref}$, dann spricht der Schwellwertschalter an und öffnet den Schalter S2, so daß die Spannung $U_h$ wegfällt und der Batteriestrom bis auf wenige Milliampere gegen Null geht, da die Lampe h1 verlischt und nicht wieder eingeschaltet wird.

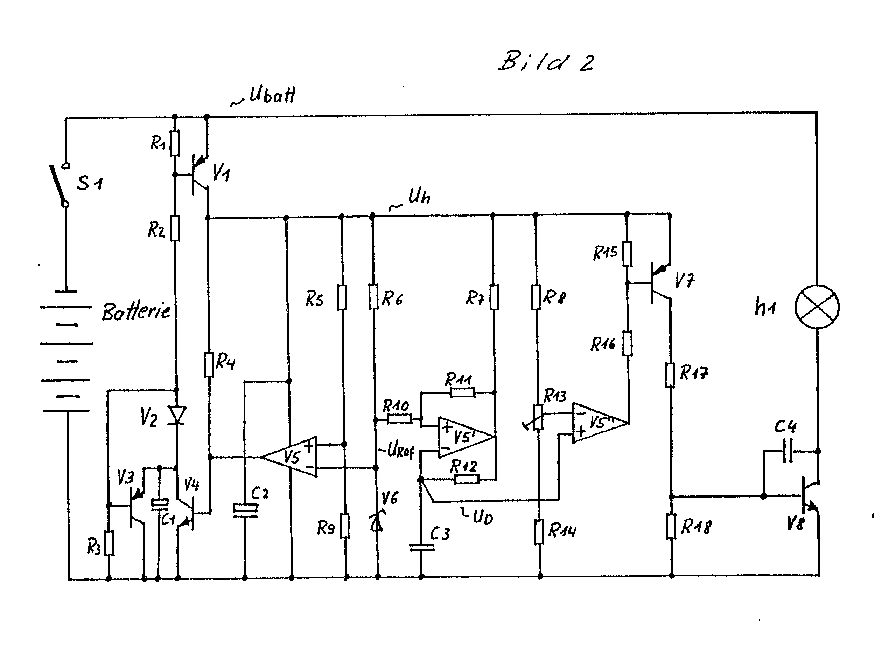

Es sei nun Bezug genommen auf Bild 2. Der Schalter S1 wird geschlossen. Dadurch fließt über das Differenzierglied, das aus einer Reihenschaltung von Widerständen $R_1$, $R_2$, einer Diode V2 und einer Kapazität C, besteht und parallel zu der Reihenschaltung von Batterie 11 und dem Schalter S1 parallel geschaltet ist, kurzzeitig ein Strom. Zwischen den beiden Widerständen $R_1$ und $R_2$ ist die Basis eines Transistors $V_1$ geschaltet, und der Spannungsabfall an dem Widerstand $R_1$ steuert die Basis des Transistors $V_1$ an, so daß jener in den leitenden Zustand geht. Dadurch wird auf die Leitung 16 die Spannung $U_h$ gegeben. Zwischen der Leitung 16 und dem Minuspol der Batterie 11 liegen ein weiterer Widerstand $R_6$ und eine Zenerdiode $V_6$, welche beiden Bauteile die Referenzschaltung bilden und somit die Referenzspannung $U_{Ref}$ bilden. Parallel zu dem Widerstand $R_6$ und der Diode $V_6$ liegt ein Spannungsteiler aus zwei Widerständen $R_5$ und $R_9$; in einem Vergleicher $V_5$ wird die von den beiden Widerständen $R_5$ und $R_9$ geteilte Spannung mit der Referenzspannung $U_{Ref}$ verglichen; der Minus-Eingang liegt zwischen dem Widerstand $R_6$ und er Diode $V_6$. Der Ausgang des Komparators ist an die Basis eines Transistors $V_4$ geschaltet und zwischen dem Kollektor des Transistors $V_1$ und der Basis des Transistors $V_4$ befindet sich ein Widerstand $R_4$. Wenn nun der Referenzwert $U_{Ref}$ größer ist als der Spannungsteilerwert $R_5/R_9$, dann wird der Transistor $V_4$ von dem Komparator $V_5$ in den leitenden Zustand gesteuert und über Widerstände $R_1$, $R_2$ und Diode $V_2$ bleibt der Transistor $V_1$ leitend; die Schaltung versorgt sich selbst (Selbsthalteschaltung).

Die Oszillatorschaltung ist gebildet aus einem Widerstand $R_{10}$, dessen eines Bein zwischen die Zener-Diode und dem Widerstand $R_6$ geschaltet ist, einem Widerstand $R_{11}$, der zum Widerstand $R_{10}$ in Reihe liegt, einem Widerstand $R_7$, der zu dem Widerstand $R_{11}$ in Reihe liegt und dessen anderes Bein an der Leitung 16 angeschlossen ist, einem Widerstand $R_{12}$, der parallel zu dem Minus-Eingang und dem Ausgang eines Komperators $V_5'$ ge-

schaltet ist, dessen positiver Eingang zwischen den Widerständen $R_{10}$ und $R_{11}$ angeschlossen ist und dessen Ausgang ebenfalls zwischen den Widerständen $R_7$ und $R_{11}$ eingeschaltet ist, und einer Kapazität $C_3$, die zwischen dem Minus-Eingang des Komperators $V_5'$ und dem Minuspol der Batterie liegt. Der Widerstand $R_{12}$ liegt mit seinem einen Bein zwischen dem Minus-Anschluß des Komperators $V_5'$ und der Kapazität $C_3$ und mit dem anderen Bein am Ausgang des Komperators $V_5'$. Diese Oszillatorschaltung erzeugt eine Dreieckspannung $U_D$ einer Kapazität, die den Höchstwert von

$$U_{Ref} + \frac{R_{10} + R_{11} + R_8}{R_{10}}$$

und einen Niedrigstwert von

$$U_{Ref} - \frac{R_{10} + R_{11}}{R_{10}}$$

besitzt. Die Frequenz des Oszillators wird durch die Widerstände $R_{12}$, $R_{10}$, $R_{11}$ und $R_7$ und die Kapazität $C_3$ bestimmt und liegt aufgrund entsprechender Dimensionierung dieser Teile zwischen 100 bis 500 Hertz. Diese Dreieckspannung $U_D$ wird dem positiven Eingang eines weiteren Komperators $V_5''$ zugeführt; der negative Anschluß des Komperators $V_5''$ liegt am Mittelabgriff eines Potentiometers $R_{13}$, der über weitere Widerstände $R_8$ und $R_{14}$ einerseits mit der Leitung $U_h$ und andererseits mit dem Minuspol der Batterie verbunden ist. Diese Dreiecksspannung $U_D$ wird vom Vergleicher $V_5''$ über den Spannungsteiler $R_8$, $R_{13}$, $R_{14}$ mit der Spannung $U_h$ verglichen. Liegt diese geteilte Spannung aus $U_h$ über dem Höchstwert von $U_D$, dann wird über einen am Ausgang des Komparators $V_5''$ anliegenden Spannungsteiler aus den beiten Widerständen $R_{15}$ und $R_{16}$ die Basis eines Transistors $V_7$ angesteuert, so daß der Transistor $V_7$, dessen Emitter an der Leitung 16 anliegt, leitend und über einen im Kollektorkreis liegenden Spannungsteiler aus den Widerständen $R_{17}$ und $R_{18}$ auch der Schalttransistor $V_8$ dauernd leitend; die Basis des Transistors ist über den Widerstand $R_{16}$ am Kollektor $V_7$ angeschlossen. Parallel zur Basis-Emitterstrecke des Transistors $V_8$ liegt der Widerstand $R_{18}$.
Parallel zu der Basis-Kollektorstrecke liegt eine Kapazität $C_4$. Wenn der Transistor $V_8$ leitend ist, brennt die Glühlampe h1. Sinkt im Laufe der Entladung die Batteriespannung ab, so sinkt auch die Spannung $U_h$ ab. Unterschreitet diese Spannung am invertierenden Eingang des Vergleichers $V_5''$ den Höchstwert von $U_D$, dann erscheint am Ausgang des Komparators $V_5''$ ein pulslängen-moduliertes Signal. Die beiden Transistoren $V_7$ und $V_8$ werden nun getaktet betrieben. Das Taktverhältnis ist abhängig von $U_h$ und bestimmt den Gleichstrommittelwert durch die Glühlampe h1. Der Lichtstrom nimmt überproportional über der Abnahme der Spannung $U_h$ bzw. $U_{batt}$ ab.

Sinkt die Batteriespannung weiter, dann sinkt auch die Spannung am nichtinvertierenden Eingang des Komparators $V_5$. Unterschreitet diese den Wert von $U_{Ref}$, dann schaltet der Komperator $V_5$ gegen Null und der Transistor $V_4$ sperrt; damit wird über die Diode $V_2$, den Widerstand und den Widerstand $R_2$ auch der Transistor $V_1$ in den Sperrzustand gefahren. Die Schaltung nimmt sich dadurch die Versorgungsspannung $U_h$, wodurch der Tiefentladeschutz mit Wiedereinschaltsperre erzeugt wird. Ein erneutes Aktivieren der gesamten Schaltung ist nur durch Öffnen und Wiederschließen des Schalters $S_1$ möglich.

Durch das erfindungsgemäße Verfahren bzw. durch die erfindungsgemäße Schaltungsanordnung wird folgendes erreicht:

Bei genügend hoher Batteriespannung ist die Lampe dauernd eingeschaltet. Sinkt im Laufe der Entladung die Zellenspannung z.B. einer Nickel-Cadmium-Batterie auf einen Wert von weniger als 1 Volt/Zelle, dann wird der Lichtstrom der Glühlampe überproportional heruntergestellt. Dem Benutzer wird dadurch erkenntlich, daß die Batteriekapazität am Ende ist. Durch die Verringerung des Lampenstromes wird die Restkapazität zur Verlängerung der Brenndauer genutzt. Kurz vor Ansprechen des Tiefentladeschutzes hat der Lichtstrom so kleine Werte, daß der Benutzer die Leuchte u.U. selbst abschaltet.

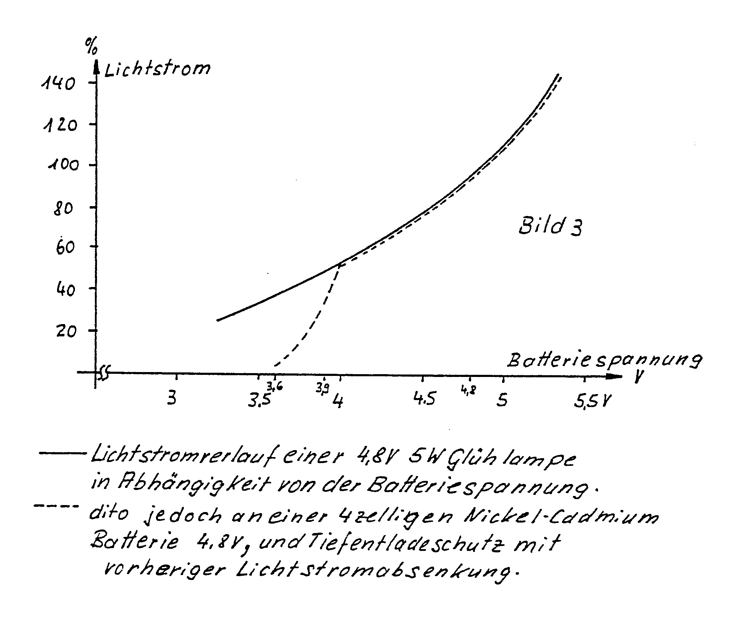

Bei einer speziellen Ausgestaltung einer Batterie mit vier Nickel-Cadmium-Zellen wird bei einer Batteriespannung kleiner 4 Volt, d.h. 1 Volt/Zelle der Lichtstrom zurückgefahren. Bei 0,9 Volt/Zelle beträgt der Lichtstrom noch ca. 5 % und bei diesem Wert, d.h. bei 3,6 Volt Batteriespannung, spricht der Tiefentladeschutz an. Es sei hierbei Bezug genommen auf Bild 3. Man erkennt ausgezogen den Lichtstromverlauf einer 4,8 Volt, 5 Watt-Glühlampe in Abhängigkeit von der Batteriespannung. Die strichlierte Linie verläuft bis zu einer Batteriespannung von 3,9 Volt exakt auf der ausgezogenen Linie. Bei weiterem Absinken der Batteriespannung, d.h. also Abnahme der Kapazität, sinkt der Strom durch den Verbraucher aufgrund der erfindungsgemäßen Schaltungsanordnung überproportional bis zu dem Wert von 3,6 Volt Batteriespannung an. Bei dieser Spannung spricht der Tiefentladeschutz an und trennt die Lampe h1 von der Batterie.

**Ansprüche**

1. Verfahren zur Erzielung eines Tiefentladeschutzes für eine wiederaufladbare Batterie, mit der ein Verbraucher versorgt wird, <u>dadurch gekenn-zeichnet,</u> daß bei Unterschreiten der Batteriespannung unter einen vorgegebenen ersten Wert die Versorgungsspannung für den Verbraucher zunächst periodisch getaktet unterbrochen wird, so daß der Spannungsmittelwert der Spannung am Verbraucher reduziert wird, und daß bei Unterschreitung der Batteriespannung unter einen vorgegebenen zweiten Wert die Versorgungsspannung abgeschaltet wird.

2. Verfahren nach Anspruch 1, dadurch gekennzeichnet, daß nach Unterschreiten des vorgegebenen ersten Wertes der Batteriespannung mit absinkender Batteriespannung sich die Ausschaltzeit verlängert.

3. Schaltungsanordnung zur Durchführung des Verfahrens nach einem der Ansprüche 1 und 2, dadurch gekennzeichnet, daß in dem Lampen-stromkreis (10) ein Taktschalter ($S_3$) geschaltet ist, der von einer Vergleicherschaltung getaktet ein-und ausschaltbar ist.

4. Schaltungsanordnung nach Anspruch 3, dadurch gekennzeichnet, daß der Taktschalter ($S_3$) ein Transistorschalter ($V_8$) ist, dessen Basis mit dem Ausgang eines Komperators ($V_5''$) verbunden ist, dessen Minus-Anschluß mit einem Spannungsteiler und dessen positiver Eingang mit einer Oszillatorschaltung verbunden ist.

5. Schaltungsanordnung nach Anspruch 4, dadurch gekennzeichnet, daß die Oszillator-schaltung (19) einen Vergleicher ($V_5'$) aufweist, an dessen negativem Eingang eine Kapazität ($C_3$) angeschlossen ist, die auf den positiven Eingang des Komperators ($V_5''$) aufgeschaltet ist.

Bild 1

0 240 883

Bild 2

0 240 883

Bild 3

―――― Lichtstromverlauf einer 4,8V 5W Glüh lampe
in Abhängigkeit von der Batteriespannung.

- - - - dito jedoch an einer 4zelligen Nickel-Cadmium
Batterie 4,8V, und Tiefentladeschutz mit
vorheriger Lichtstromabsenkung.